# EUROPEAN PATENT APPLICATION

(11) **EP 2 299 492 A1**
(43) Date of publication of application: **23.03.2011**
(21) Application number: 09171006.1
(22) Date of filing: 22.09.2009
(51) Int. Cl.: H01L 27/28

(54) **Integrated circuit**

(71) Applicant: Nederlandse Organisatie voor Toegepast -Natuurwetenschappelijk Onderzoek TNO, 2628 VK Delft (NL); IMEC vzw, 3001 Leuven-Heverlee (BE)
(72) Inventor: Gelinck, Gerwin Hermanus, 5551 HT Valkenswaard (NL); Kjellander, Birgitta Katarina Charlotte, 2470 Retie (BE)
(74) Representative: Hatzmann, Martin

(57) **Abstract**

An integrated circuit, comprising a first insulating layer; a semiconductor layer; a first layer of conductors in near-ohmic or ohmic contact with the semiconductor layer and a second layer of conductors separated from the semiconductor layer by the first insulating layer, the first and second layers of conductors being patterned to form a plurality of functional blocks comprising a plurality of transistors, the first layer conductors serving as source/drain electrodes and the second layer conductors serving as gate electrodes;
wherein regions of the semiconductor layer corresponding to a functional block are electrically isolated from one another by portions of a second insulating layer, the functional blocks being arranged such that (i) neighbouring source/drain electrodes from different transistors are arranged to be at the same potential and (ii) no conductors are present between the neighbouring electrodes.

## Description

The present invention relates to an integrated circuit comprising thin film transistors in which there is a near-ohmic or ohmic connection from the source/drain electrodes into the semiconductor layer.

The present invention has particular application, for example, to circuits that use an organic material in the active semiconductor layer. The present invention may also be applied to circuits based on other material systems such as inorganic semiconductors like metal oxides.

It is known that, in such circuits, there is an undesirable tendency for current to leak from a transistor into a surrounding part of the system. One approach to counteracting the current leakage is to pattern the semiconductor layer. US 6362509 discloses an alternative approach, in which an organic semiconductor layer remains substantially unpatterned, and the transistors themselves are arranged to prevent leakage current across the semiconductor layer (column 1, lines 55 - 64).

In contrast, the present invention provides an integrated circuit in which the semiconductor layer is partitioned into electrically isolated regions and the transistors are arranged in a way which facilitates the co-location of multiple transistors on the electrically isolated regions.

More specifically, according to an aspect of the present invention, there may be provided an integrated circuit, comprising
a first insulating layer;
a semiconductor layer;
a first layer of conductors in near-ohmic or ohmic contact with the semiconductor layer and a second layer of conductors separated from the semiconductor layer by the first insulating layer, the first and second layers of conductors being patterned to form a plurality of functional blocks comprising a plurality of transistors, the first layer conductors serving as source/drain electrodes and the second layer conductors serving as gate electrodes;
wherein regions of the semiconductor layer corresponding to a functional block are electrically isolated from one another by portions of a second insulating layer, the functional blocks being arranged such that (i) neighbouring source/drain electrodes from different transistors are arranged to be at the same potential and (ii) no conductors are present between the neighbouring electrodes.

By creating functional blocks on electrically isolated regions of semiconductor material, the present invention tends to reduce undesired current leakage through the semiconductor layer to other parts of the circuit. In addition, by arranging that within a functional block criteria (i) and (ii) are met, it is ensured that there is no potential difference between neighbouring source/drain electrodes from different transistors which might cause undesired leakage between them. As a result, multiple transistors forming a functional block may readily be co-located on an electrically isolated region and each functional block is more robust to placement accuracy and other manufacturing errors. This facilitates further downscaling of transistor size.

Preferably, within the functional blocks, for each transistor, the source/drain electrodes are interdigitated and comprise a plurality of parallel fingers pointed in a first longitudinal direction. Such a geometry of fingers further assists in preventing undesired leakage from one transistor to its neighbour when the outer fingers from each transistor are (nominally) at the same potential.

Preferably, within the functional blocks, for each transistor, a said gate electrode is in vertical alignment with corresponding source/drain electrodes.

Preferably, the gate electrode is sized such that its perpendicular projection onto the first layer conductors overlaps with all the corresponding source/drain electrodes and extends in a second lateral direction, perpendicular to the first longitudinal direction, beyond both outer fingers.

In a first preferred embodiment, the portions of the second insulating layer are arranged such that said regions of the semiconductor layer corresponding to a functional block comprise islands. As the semiconductor layer is not continuous, the degree of electrical isolation is high and hence the flow of undesired leakage current across the semiconductor layer is greatly reduced. In this embodiment, the semiconductor is applied by local deposition within a cavity defined by the second insulating layer.

Preferably, for each transistor, the gate electrode is sized such that its perpendicular projection onto the semiconductor layer extends in the first longitudinal direction beyond the semiconductor island. This is advantageous for normally-on transistors because the semiconductor material can transport charge carriers from source to drain and/or vice versa when the applied voltage on the gate electrode is zero or higher. The presence of any semiconductor material beyond the said projection of the gate electrode creates a leakage path between the source and drain since there is no means to interrupt charge transport.

Preferably, for each transistor, the gate electrode is sized such that its perpendicular projection onto the semiconductor layer falls, in a second lateral direction, within the semiconductor island. This is advantageous since if it does not fall within the semiconductor island as stated a small deviation in the overlay between the semiconductor layer and the underlying layers has a negative impact on the transistor performance characteristics. The impact can be particularly pronounced when the integrated circuit forms part of a display as the overlay mismatch has a direct negative impact on the perception of display quality.

In a second preferred embodiment, the semiconductor layer is applied by blanket deposition to the first layer conductors and the second insulating layer. Although the semiconductor layer is continuous, leakage current is nonetheless reduced, albeit to a lesser extent than in the first embodiment, because, in the vicinity of a said portion of the second insulating layer, (a) the electrical coupling to the gate electrode is low, (b) the semiconductor material is not in direct contact with any charge injecting (source/drain) contacts and (c) the poor coverage of vertical sides of the portions of the second insulating layer with the semiconductor material.

Exemplary embodiments of the invention are hereinafter described with reference to the accompanying drawings, in which:
Figures 1(a) and 1(b) show diagrammatic views from above (with the semiconductor layer omitted) and in cross-section, respectively, of a functional block of three transistors constructed according to the principles of the present invention;
Figures 2(a) and 2(b) show a circuit representation and a schematic view from above of a physical representation, respectively, of a NAND gate;
Figures 3(a) and 3(b) show a circuit representation and a view from above of a physical representation, respectively, of a pixel engine of a smart sensor; and
Figure 4 shows a diagrammatic cross-sectional view of two functional blocks constructed according to the principles of the present invention.

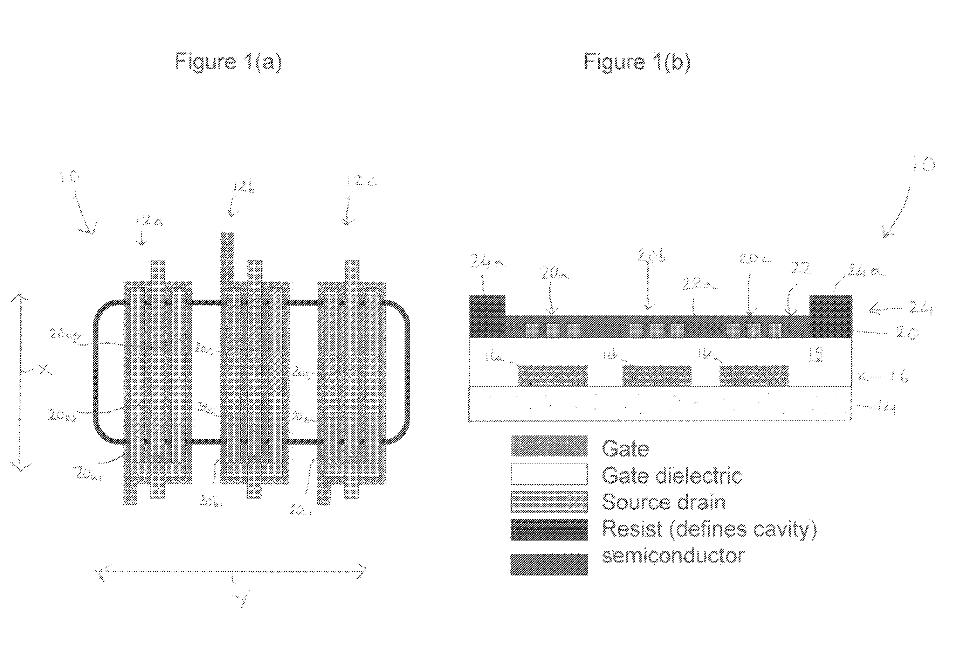

An integrated circuit in accordance with a first preferred embodiment of the invention is generally designated 10. Figures 1(a), (b) show a single functional block from the circuit 10. The integrated circuit 10 is constructed from thin film field effect transistors (FET) that use an organic material in the active semiconductor layer. The single functional block shown in Figures 1(a), (b) comprises an exemplary three transistors designated 12a, 12b, 12c. Referring specifically to Figure 1(b), the circuit 10 comprises a substrate 14 having an electrically insulating surface. The circuit 10 further comprises a layer of conductors 16 which constitutes the gate electrodes 16a, 16b, 16c of the transistors. The circuit 10 further comprises an insulating layer 18 which constitutes the gate dielectric for the transistors. The circuit 10 further comprises a layer of conductors 20 which constitute the source/drain electrodes 20a, 20b, 20c of the transistors. The circuit 10 further comprises a semiconductor layer 22 comprising an island of organic semiconductor material 22a which constitutes the active semiconductor layer of the transistors. The semiconductor material preferably has a thickness of 2 - 5 µm. The source/drain electrodes 20a, 20b, 20c are in near-ohmic contact with the semiconductor material 22a. The circuit 10 further comprises a layer of insulating resist material 24. A portion 24a of the layer 24 completely surrounds the island of semiconductor material 22a and provides a continuous perimeter wall.

The physical and electrical isolation of the island of semiconductor material 22a by the insulating resist material 24 greatly reduces undesired current leakage through the semiconductor layer 22 through to other parts of the circuit.

In order to co-locate the transistors 20a, 20b, 20c on the same island in very close proximity while preserving their ability to operate properly, the source/drain electrodes are arranged as, taking transistor 20a as an example, a set of interdigitated fingers 20a₁, 20a₂, 20a₃, the fingers 20a₁, 20a₂, 20a₃ being parallel to one another and having a longitudinal direction extending across the island in direction illustrated by axis X in Figure 1(a). In order to ensure a minimum of interference, that is current leakage, between the transistors 12a, 12b, 12c, no matter what functional circuit they are connected together to form, it is ensured that there is no potential difference between neighbouring fingers of different transistors, that is between fingers 20a₃ and 20b₁, and fingers 20b₃ and 20c₁, and that no further conductors which may form part of the functional block (none are shown in the drawing) are present therebetween.

It will be noted that, for each transistor 12a, 12b, 12c and taking transistor 12a as an example, the gate electrode 16a is in general vertical alignment with the corresponding source/drain electrodes 20a, and the perpendicular projection of the gate electrode 16a onto the semiconductor layer 22, in a direction along the island indicated by the axis Y in Figure 1(a), extends completely across the fingers and beyond both outer fingers 20a₁ and 20a₃.

It will be further noted that, for each transistor 12a, 12b, 12c and taking transistor 12a as an example, the gate electrode 16a is sized such that its perpendicular projection onto the semiconductor layer 22 extends in the direction X direction beyond the semiconductor island 22a. This is advantageous for normally-on transistors because the semiconductor material can transport charge carriers from source to drain and/or vice versa when the applied voltage on the gate electrode 16a is zero or higher. The presence of any semiconductor material beyond the projection of the gate electrode creates a leakage path between the source and drain since there is no means to interrupt charge transport.

It will be still further noted that, for each transistor 12a, 12b, 12c and taking transistor 12a as an example, the gate electrode 16a is sized such that its perpendicular projection onto the semiconductor layer 22 falls in the direction Y within the semiconductor island 22a. This is advantageous since if it does not fall within the semiconductor island 22a as stated a small deviation in the overlay between the semiconductor layer 22 and the underlying layers has a negative impact on the transistor performance characteristics. The impact can be particularly pronounced when the integrated circuit forms part of a display as the overlay mismatch has a direct negative impact on the perception of display quality.

The integrated circuit 10 is made by conventional techniques. In particular, provision of a layer comprising islands of semiconductor material can be achieved in a number of ways, for example, by photolithography, embossing and contact printing. In such cases, it is preferred to provide the resist structure including surrounding channel together, as part of one layer. The layer can be a photoresist or a dielectric layer that is patterned with an additional mask. It need not be a pattern with a height difference. In another embodiment, the area is made of hydrophobic-oleophilic patterns made by surface energy modifications. In addition, vapour phase deposition of the semiconductor through a shadow mask or any other direct deposition technique may also be used.

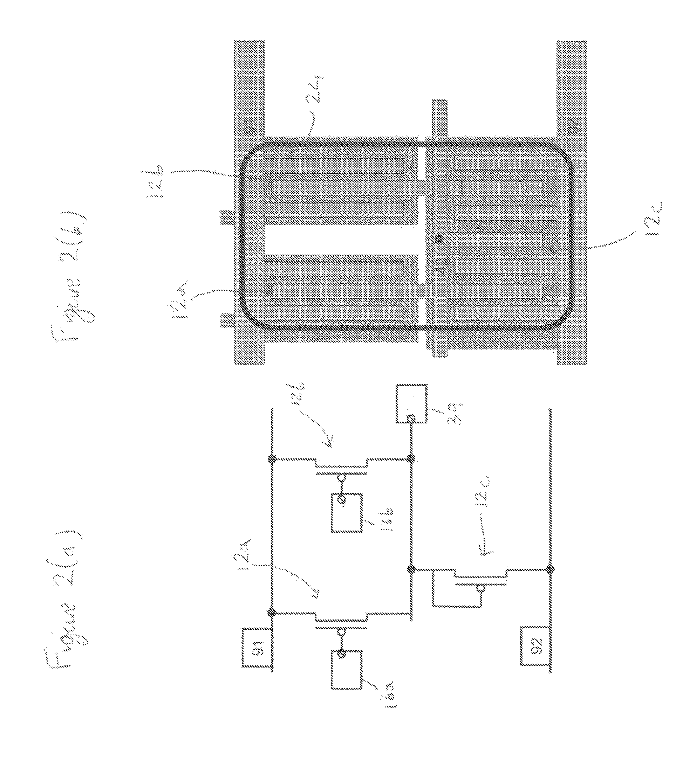

In Figures 2(a), (b), 3(a), (b) and 4, where parts similar to those in Figures 1(a), 1(b) exist, the same reference numerals have been used.

As is well-known, from a 2-input NAND logic gate, all other possible logic and digital circuits can be constructed. Figure 2(a) shows a usual circuit representation of a NAND gate implemented using FET transistors. There are three transistors 12a, 12b, 12c, with transistors 12a, 12b, serving as the driver transistors to which the input logic signals are supplied via gate electrodes 16b, 16c. The two supply lines are labeled 91, 92. The output logic state is present at line 39. Figure 2(b) shows a physical representation of the circuit constructed in accordance with the principles explained with reference to Figures 1(a) and 1(b). The output logic state is accessed via a vertical interconnect area 42.

Similarly, it is possible to construct NOR gates in accordance with a further embodiment of the present invention.

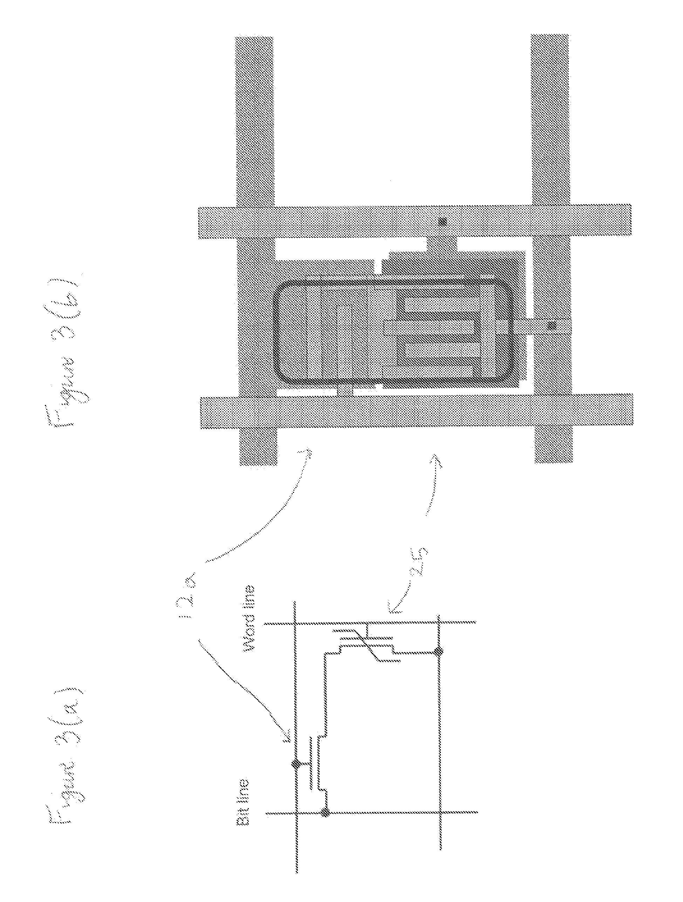

Figure 3(a) shows a circuit representation of a pixel engine of a smart sensor. The circuit can serve as a non-volatile memory cell. A ferroelectric transistor 25, providing the non-volatile memory function, is combined with a transistor 12a that selects the cell. The circuit can be constructed in accordance with the principles explained with reference to Figure 1(a) and 1(b) as shown ins Figure 3(b), although in this case the structure of the dielectric layer is different in the region the ferroelectric transistor 25.

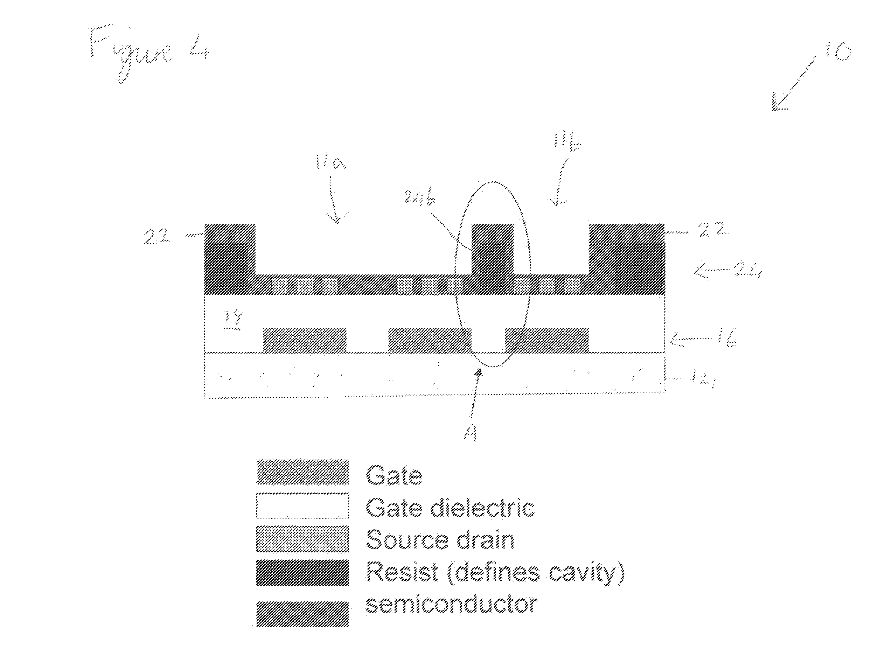

An integrated circuit 10 in accordance with a second preferred embodiment of the invention is shown in Figure 4. This embodiment differs from that shown in Figures 1(a), (b) in that instead of being arranged as islands, the semiconductor layer 22 is a continuous layer which is applied by blanket deposition to the layer of conductors 20 and the insulating resist layer 24. In the portion of the circuit 10 shown in Figure 4, there are two functional blocks 11a, 11b divided by a portion 24b of the insulating resist layer 24. Although the semiconductor layer 22 extends continuously from one functional block 11a to the other functional block 11b, because, in the vicinity of the portion 24b, see region A, the electrical coupling to the gate electrodes 16b, 16c is low, the semiconductor material 22 is not in direct contact with any charge injecting (source/drain) contacts; and the poor coverage of the vertical side of the portion 26 with semiconductor material 22, the portion 24b still provides an appreciable electrical isolating effect.

In other embodiments, the semiconductor layer 22 may comprise more than one semiconductor material. For example, regions of p/p, n/n or p/n-type semiconductors and combinations thereof may be applied to the same substrate 14. In such instances, it will be appreciated that a given functional block comprises only one type of semiconductor.

## Claims

1. An integrated circuit, comprising
a first insulating layer;
a semiconductor layer;
a first layer of conductors in near-ohmic or ohmic contact with the semiconductor layer and a second layer of conductors separated from the semiconductor layer by the first insulating layer, the first and second layers of conductors being patterned to form a plurality of functional blocks comprising a plurality of transistors, the first layer conductors serving as source/drain electrodes and the second layer conductors serving as gate electrodes;
wherein regions of the semiconductor layer corresponding to a functional block are electrically isolated from one another by portions of a second insulating layer, the functional blocks being arranged such that (i) neighbouring source/drain electrodes from different transistors are arranged to be at the same potential and (ii) no conductors are present between the neighbouring electrodes.

2. An integrated circuit as in claim 1, wherein, within the functional blocks, for each transistor, the source/drain electrodes are interdigitated and comprise a plurality of parallel fingers pointed in a first longitudinal direction.

3. An integrated circuit as in claim 2, wherein, within the functional blocks, for each transistor, a said gate electrode is in vertical alignment with corresponding source/drain electrodes.

4. An integrated circuit as in claim 3, wherein, for each transistor, the gate electrode is sized such that its perpendicular projection onto the first layer conductors overlaps with all the corresponding source/drain electrodes and extends in a second lateral direction, perpendicular to the first longitudinal direction, beyond both outer fingers.

5. An integrated circuit as in any preceding claim, wherein the portions of the second insulating layer are arranged such that said regions of the semiconductor layer corresponding to a functional block comprise islands.

6. An integrated circuit as in claims 3 or 4, wherein, for each transistor, the gate electrode is sized such that its perpendicular projection onto the semiconductor layer extends in the first longitudinal direction beyond the semiconductor island.

7. An integrated circuit as in claims 5 or 6, wherein, for each transistor, the gate electrode is sized such that its perpendicular projection onto the semiconductor layer falls, in a second lateral direction perpendicular to the first longitudinal direction, within the semiconductor island.

8. An integrated circuit as in any preceding claim, wherein the semiconductor layer comprises a continuous layer applied to the first layer conductors and the second insulating layer.

9. An integrated circuit as in any preceding claim, further comprising a substrate.

10. An integrated circuit as in any preceding claim, wherein a said functional block comprises a non-volatile memory cell.

11. An integrated circuit as in any preceding claim, wherein a said functional block comprises a NAND or NOR logic gate.
